# FASCICULE DE BREVET EUROPEEN

(11) **EP 2 647 274 B1**
(45) Date de publication et mention de la délivrance du brevet: **13.01.2021**
(21) Numéro de dépôt: 11801789.6
(22) Date de dépôt: 29.11.2011
(51) Int. Cl.: H05K 9/00, H01Q 1/24, H01Q 1/52

(54) **SURFACE TEXTILE ET MATÉRIAU TEXTILE POUR ABSORBER LES ONDES ÉLECTROMAGNÉTIQUES, ET DISPOSITIF DE PROTECTION COMPORTANT UNE SURFACE TEXTILE OU UN MATÉRIAU TEXTILE**
TEXTILE FLÄCHE UND TEXTILMATERIAL ZUR ABSORPTION ELEKTROMAGNETISCHER WELLEN UND SCHUTZVORRICHTUNG MIT TEXTILER OBERFLÄCHE ODER TEXTILMATERIAL
TEXTILE SURFACE AND TEXTILE MATERIAL FOR ABSORBING ELECTROMAGNETIC WAVES, AND PROTECTIVE DEVICE COMPRISING A TEXTILE SURFACE OR TEXTILE MATERIAL

(30) Priorité: 30.11.2010 FR 1059916
(43) Date de publication de la demande: 09.10.2013
(73) Titulaire: Calicea, 75002 Paris (FR)
(72) Inventeur: MOULEYRE, Christian, F-69450 Saint Cyr Au Mont D'Or (FR)
(74) Mandataire: Chevalier, Renaud Philippe
(86) Numéro de dépôt international: PCT/FR2011/052811
(87) Numéro de publication internationale: WO 2012/072945

(56) Documents cités:
- EP-A1- 1 148 774
- WO-A1-2010/033093
- DE-A1-102006 007 518
- US-A1- 2007 159 753
- US-B1- 6 855 883

## Description

L'invention concerne une surface textile et un matériau textile pour absorber au moins partiellement les ondes électromagnétiques, ainsi qu'un dispositif de protection contre les ondes électromagnétiques comportant une zone de protection présentant une surface textile ou un matériau textile.

Avec l'essor des moyens de communications sans fil, tels que la téléphonie mobile ou les connexions internet sans fil, il existe une inquiétude grandissante vis-à-vis des ondes électromagnétiques et des risques pour la santé qui y sont liés.

En effet, les ondes électromagnétiques émises pour les communications sans fil, et plus particulièrement pour la téléphonie mobile, sont dans la gamme de fréquence des micro-ondes. Cette gamme de fréquence est notamment connue pour son interaction avec la molécule d'eau qui compose le corps humain à 70%. Il est donc envisageable, comme certaines études scientifiques tendent à le faire penser, que ces ondes aient une influence directe sur la santé.

Pour ce prémunir de ces risques, il est connu d'utiliser des surfaces textiles, telles que celles décrites dans le document US 6855883, permettant d'absorber une partie des ondes électromagnétiques et donc, lorsqu'elles équipent un dispositif de protection, de limiter les expositions à de telles ondes.

De telles surfaces textiles sont généralement obtenues par le tissage de fils conducteurs métalliques entre eux. Les propriétés d'absorption de ces surfaces sont directement liées à la conductivité du métal constituant les fils et à la densité du tissage. Il en résulte donc qu'une surface textile présentant de bonnes propriétés d'absorption des ondes électromagnétiques requiert l'utilisation d'un métal de forte conductivité, tel que l'or, l'argent ou le cuivre, avec une densité de tissage importante.

De tels surfaces textiles sont donc relativement couteuses ce qui limite leur exploitation à grande échelle. Le document WO2010033093 divulgue un élément textile qui utilise des fibres recouvertes d'un métal et des fibres de polypropylène,

L'invention vise à remédier à cet inconvénient.

Un but de l'invention est donc de fournir une surface textile présentant des qualités d'absorption des ondes électromagnétiques similaires à celles d'une surface textile réalisée entièrement en un métal de très forte conductivité tout possédant un coût de production bien inférieur.

A cet effet, l'invention concerne une surface textile pour absorber au moins partiellement des ondes électromagnétiques, comportant des éléments textiles, tels que des fils ou des fibres, d'au moins un premier et un deuxième types, les éléments textiles du premier et du deuxième types présentant des propriétés de conduction électrique, chaque élément textile du premier type comportant une âme en matière synthétique recouverte d'un premier métal, les éléments textiles du deuxième type étant réalisés dans un deuxième métal.

Une telle surface textile permet, en utilisant des éléments textiles d'un premier type comportant une âme en matière synthétique recouverte d'un métal de forte conductivité, avec des éléments textiles d'un deuxième type réalisés en un métal de plus faible coût, d'obtenir une qualité d'absorption similaire à celle d'une surface textile réalisée entièrement à partir d'éléments textiles en métal de forte conductivité tout en présentant des coûts de production bien inférieurs. En effet, le métal, de forte conductivité, pouvant être utilisé en tant que revêtement sur une âme en matière synthétique, il n'augmente pas significativement le coût de la surface textile tout en offrant, par sa coopération avec le métal formant les éléments textiles du second type, une bonne qualité d'absorption des ondes électromagnétiques.

Avantageusement, le premier métal est de l'argent.

L'argent est un métal noble présentant une forte conductibilité qui permet donc à la surface textile de présenter une bonne qualité d'absorption des ondes électromagnétiques.

Préférentiellement, l'âme des éléments textiles du premier type est réalisée dans un polymère du type polyamide.

Une telle matière permet de fournir une âme pour les éléments textiles du premier type robuste et de faible coût.

De manière préférentielle, le deuxième métal est de l'acier ou un alliage d'acier.

L'acier permet de fournir des éléments textiles du deuxième type qui présentent à la fois une bonne conductivité et un coût réduit.

Avantageusement, la surface textile comporte en outre des éléments textiles d'un troisième type, réalisés en matériau isolant électriquement, tel que du polyester.

Un tel troisième type d'éléments textiles permet de faciliter la réalisation de la surface textile, ces éléments textiles permettant, lorsqu'ils sont combinés avec des éléments textiles métalliques de fournir des fils possédant la souplesse nécessaire pour le tissage ou tricotage.

De manière avantageuse, la surface textile comporte des torons ou des fils guipés obtenus respectivement par le retordage ou le guipage d'au moins un élément textile du troisième type avec au moins un élément textile du premier type ou du deuxième type.

La formation de torons ou de fils guipés à partir d'éléments textiles du troisième type avec des éléments du premier ou du deuxième types permet de fournir des fils ou des fibres possédant la souplesse nécessaire pour le tissage ou tricotage.

Avantageusement, la surface textile est obtenue par tissage.

Le tissage permet d'obtenir une surface textile présentant, pour une épaisseur donnée, une densité d'éléments textiles conducteurs qui soit maximale.

Préférentiellement, la surface textile présente des fils de trame comportant des éléments textiles du premier ou du deuxième type, la surface textile présentant des fils de chaîne comportant des éléments textiles d'un type différent, parmi les éléments textiles du premier et du deuxième types.

De manière avantageuse, la surface textile est constituée à partir de fils de polyamide recouverts d'argent pour les fils de trame ou de chaîne et de fils en acier inoxydable/polyester pour les fils respectivement de chaîne ou de trame.

L'invention se rapporte également à un matériau textile pour absorber au moins partiellement les ondes électromagnétiques comportant au moins deux couches formées chacune d'une surface textile selon l'invention.

Un tel matériau textile permet d'obtenir une absorption de bonne qualité des ondes électrostatiques puisqu'il combine l'absorption d'au moins deux couches de surfaces textiles.

L'invention se rapporte également à un dispositif de protection contre les ondes électromagnétiques destiné à loger un téléphone portable, le dispositif comportant :
- un logement destiné à recevoir le téléphone portable et
- au moins une zone de protection destinée à être interposée entre la tête d'un utilisateur et le téléphone portable, ladite zone de protection comportant une surface textile selon l'invention ou un matériau textile selon l'invention.

Un tel dispositif permet à l'utilisateur de se protéger des ondes électromagnétiques émisses par le téléphone portable lors d'un appel téléphonique.

Avantageusement, le dispositif comporte un clapet qui, comportant la zone de protection, est mobile entre une position ouverte dans laquelle le clapet est destiné à être positionné en retrait du téléphone portable reçu dans le logement, et une position fermée dans laquelle le clapet est destiné à être positionné à proximité du téléphone portable.

Plus spécifiquement, lorsque le clapet en position fermé est positionné contre la face avant du téléphone portable. Un tel clapet permet de fournir un accès au téléphone portable lors de sa manipulation tout en offrant une bonne protection contre les ondes électromagnétiques émises par le téléphone portable lors d'un appel téléphonique.

Dans une forme d'exécution préférée, le clapet est réalisé par empilement d'au moins :
- une première couche formant ladite zone de protection, réalisée dans une surface textile ou un matériau textile tel que présentés ci-avant; et
- une deuxième couche formant parement extérieur, cette deuxième couche comprenant au moins un premier orifice agencé de telle sorte que lorsque le clapet est positionné en position fermée, chaque premier orifice est positionné centré face à un microphone du téléphone portable.

Une telle disposition est avantageuse en ce qu'elle permet de fournir un dispositif esthétique dans lequel l'atténuation des ondes acoustiques captées par les microphones du téléphone portable est minimisée, lorsque le clapet est positionné en position fermée.

De préférence, la deuxième couche formant parement extérieur comprend au moins un second orifice agencé de telle sorte que lorsque le clapet est positionné en position fermée, chaque second orifice est positionné centré face à un haut-parleur du téléphone portable.

Une telle disposition est avantageuse en ce qu'elle permet de fournir un dispositif esthétique dans lequel l'atténuation des ondes acoustiques générées par le haut-parleur du téléphone portable est minimisée, lorsque le clapet est positionné en position fermée.

Par exemple, la deuxième couche est réalisée en cuir ou en matière plastique.

Suivant une caractéristique, l'empilement comprend en outre une troisième couche formant parement intérieur, cette troisième couche comprenant au moins un premier orifice, et de préférence au moins un second orifice, agencés de telle sorte que lorsque le clapet est positionné en position fermée, chaque premier orifice est positionné centré face à un microphone du téléphone portable, et chaque second orifice est positionné centré face à un haut-parleur du téléphone portable.

Par exemple, la troisième couche est réalisée en suédine.

Suivant une autre caractéristique, l'empilement comprend en outre une quatrième couche formant renfort, disposé entre les deuxième et troisième couches, cette quatrième couche comprenant au moins un premier orifice, et de préférence au moins un second orifice, agencés de telle sorte que lorsque le clapet est positionné en position fermée, chaque premier orifice est positionné centré face à un microphone du téléphone portable, et chaque second orifice est positionné centré face à un haut-parleur du téléphone portable.

Par exemple, la quatrième couche est réalisée en plexiglas.

Suivant une autre caractéristique, l'empilement comprend une cinquième couche réalisée en carton, cette cinquième couche comprenant au moins un premier orifice, et de préférence au moins un second orifice, agencés de telle sorte que lorsque le clapet est positionné en position fermée, chaque premier orifice est positionné centré face à un microphone du téléphone portable, et chaque second orifice est positionné centré face à un haut-parleur du téléphone portable.

Avantageusement, le logement est pourvu d'au moins un premier orifice agencé pour être positionné centré face à un microphone du téléphone portable, et de préférence d'au moins un second orifice agencé pour être positionné centré face à un haut-parleur du téléphone portable, lorsque ledit téléphone portable est reçu dans le logement.

Une telle disposition est avantageuse en ce qu'elle permet de fournir un logement enserrant parfaitement le téléphone portable, sans atténuer les ondes acoustiques générées par le haut-parleur du téléphone portable ou les ondes acoustiques captées par les microphones, lorsque le clapet est positionné en position fermée.

L'invention concerne enfin un ensemble caractérisé en ce qu'il comporte un téléphone portable et un dispositif tel que présenté ci-avant.

De toute façon l'invention sera bien comprise à l'aide de la description qui suit en référence au dessin schématique annexé représentant, à titre d'exemples non limitatifs, trois formes d'exécution de cette surface textile et de ce matériau textile ainsi que deux formes d'exécution de ce dispositif de protection contre les ondes électromagnétiques.
La figure 1 est une vue schématique en perspective d'une première forme d'exécution d'un dispositif de protection contre les ondes électromagnétiques pour téléphone portable ;
la figure 2 en est une vue schématique en perspective sans téléphone portable, l'habillage de la partie comprenant la surface textile ayant été arrachée ;
la figure 3 en est une vue en coupe transversale au niveau du clapet ;
la figure 4 est une vue en perspective d'une seconde forme d'exécution du dispositif de protection contre les ondes électromagnétiques sans téléphone portable, l'habillage de la partie comprenant la surface textile ayant été arraché ;
la figure 5 est une vue en perspective d'une troisième forme d'exécution du dispositif de protection contre les ondes électromagnétiques ;
la figure 6 est une première vue de dessus du dispositif de protection de la figure 5 ;
la figure 7 est une seconde vue de dessus du dispositif de protection de la figure 5 ;
la figure 8 est une vue en perspective du clapet du dispositif de protection de la figure 5. Pour les différents formes d'exécution, les même références seront utilisées pour des éléments identiques ou assurant la même fonction, par soucis de simplification de la description.

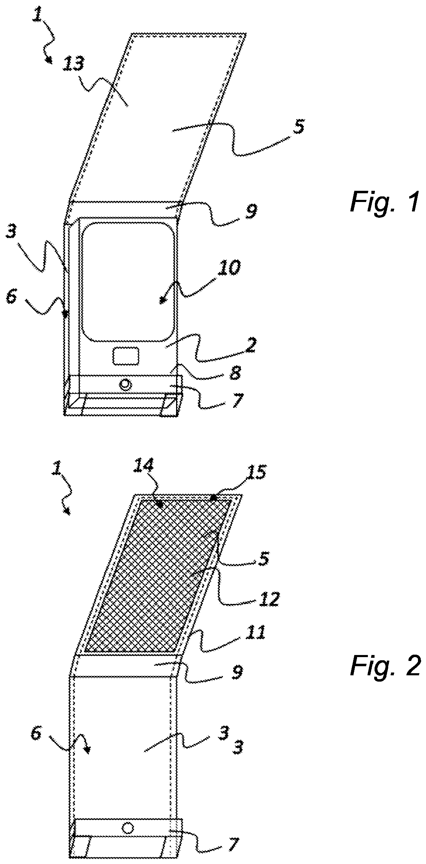

La figure 1 illustre une première forme d'exécution d'un dispositif de protection 1 contre les ondes électromagnétiques se présentant sous la forme d'une housse logeant un téléphone portable 2.

Le dispositif de protection 1 présente une première partie 3 servant au logement du téléphone portable 2 et une deuxième partie prenant la forme d'un clapet 5 ou capot.

La première partie 3 comprend une surface de support 6, de dimensions similaires à celles de la surface du téléphone portable 2 à loger, présentant des moyens de maintien du téléphone sur la surface de support 6. Sur la figure 1, les moyens de maintien prennent la forme d'un berceau 7 venant enserrer la partie basse 8 du téléphone portable 2, mais ces moyens peuvent prendre d'autres formes, telles que des bandes élastiques présentes sur la portion basse et haute de la surface de support 6.

La surface de support 6 et les moyens de maintien sont réalisés en un matériau transparent aux ondes électromagnétiques dans les gammes de fréquences utilisées dans la téléphonie mobile.

Le clapet 5 du dispositif de protection 1 est accroché sur la première partie 3 au moyen d'une bande 9 d'un matériau similaire à la surface de support 6. De cette manière le clapet 5 peut être déplacé entre une position ouverte dans laquelle il donne accès aux commandes du téléphone portable 2 et une position fermée dans laquelle il recouvre la face avant 10 du téléphone portable 2, de manière à ce qu'il s'interpose entre la tête d'un utilisateur et le téléphone portable 2 lors d'un appel téléphonique.

Le clapet 5 est de dimensions similaires à celles de la surface du téléphone portable 2.

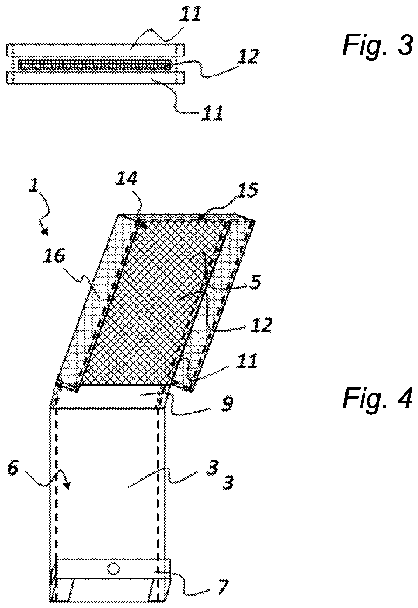

Le clapet 5, comme illustré sur les figures 2 et 3, comporte une couche textile encapsulée entre deux surfaces d'habillage 11, telles que des surfaces en cuir, en textile ou en matériau synthétique. Par souci de cohérence esthétique, les surfaces d'habillage 11 peuvent être du même type que la surface de support 6

La couche textile peut être une surface textile (non représentée), ou un matériau textile 12 comportant au moins deux surfaces textiles, adapté pour adsorber des ondes électromagnétiques. La couche textile forme une zone de protection 13 contre les ondes électromagnétiques.

Selon une première forme d'exécution de la surface textile, la surface textile est un tissu comportant des fils de trame 14 et des fils de chaîne 15.

Les fils de chaîne 15 sont formés d'une âme (non représentée), réalisée dans un polymère du type polyamide, et recouverte d'argent.

Les fils de trame 14 sont formés de torons (non représentés) réalisés par le retordage d'un fil d'acier (non représenté) avec un fil de polyester (non représenté).

Selon cette forme d'exécution, avec une composition de 54% de fils de polyamide recouvert d'argent, de 23% de fils en acier inoxydable et de 23% de fils en polyester, un matériau textile 11 comportant deux surfaces textiles juxtaposées présente des atténuations des ondes électromagnétiques mesurées selon la méthode GAM-T20 :1992 de :
- 47,4 dB pour une fréquence de 900 MHz
- 50,4 dB pour une fréquence de 1800 MHz et
- 54,8 dB pour une fréquence de 2100 MHz.

Selon une autre forme d'exécution de la surface textile, la surface textile se différencie de la forme d'exécution précédente, en ce que les fils de chaîne 15 sont formés de torons réalisés par le retordage d'un fil d'acier avec un fil de polyester et en ce que les fils de trame 14 sont formés d'une âme, réalisée dans un polymère du type polyamide, et recouverte d'argent.

Selon cette forme d'exécution, avec une composition de 32% de fils de polyamide recouvert d'argent, de 33% de fils en acier inoxydable et de 35% de fils en polyester, un matériau textile 11 comportant deux surfaces textiles juxtaposées présente des atténuations des ondes électromagnétiques mesurées selon la méthode GAM-T20 :1992 de :
- 47,8 dB pour une fréquence de 900 MHz
- 51,4 dB pour une fréquence de 1800 MHz et
- 55,4 dB pour une fréquence de 2100 MHz.

Selon une autre forme d'exécution de la surface textile, la surface textile se différencie des formes d'exécution précédentes en ce que les fils de chaîne 15 sont formés d'une âme, réalisée dans un polymère du type polyamide, et recouverte d'argent et en ce que les fils de trame 14 sont formés de 60% de torons réalisés par le retordage d'un fil d'acier avec un fil de polyester et de 40% de fils formés d'une âme, réalisée dans un polymère du type polyamide, et recouverte d'argent.

Selon cette forme d'exécution avec une composition de 75% de fils de polyamide recouvert d'argent, de 14% de fils en acier inoxydable et de 14% de fils en polyester, un matériau textile 12 comportant deux surfaces textiles juxtaposées présente des atténuations des ondes électromagnétiques mesurées selon la méthode GAM-T20 :1992 de :
- 48 dB pour une fréquence de 900 MHz
- 51 dB pour une fréquence de 1800 MHz et
- 55 dB pour une fréquence de 2100 MHz.

La surface textile peut également être une surface textile formée selon un procédé de production autre que le tissage, tel que le tricotage ou la formation d'une surface en non tissé.

Lors de l'utilisation du dispositif de protection 1, le téléphone portable 2 est positionné dans les moyens de maintien. Ainsi, l'utilisateur possède un accès aux commandes du téléphone portable 2 en positionnant le clapet 5 en retrait du téléphone portable 2 et est également protégé des ondes électromagnétiques émises par le téléphone portable 2 lorsque le clapet 5 est en appui sur la face avant 10 du téléphone portable 5.

La figure 4 illustre une seconde forme d'exécution du dispositif de protection 1. Un tel dispositif de protection 1 se différencie d'un dispositif de protection 1 selon la première forme d'exécution en ce qu'il présente sur les bords du clapet 5 des parois latérales 16 présentant une couche textile pour parfaire la protection contre les ondes électromagnétiques lors d'un appel téléphonique.

Ce dispositif de protection 1 permet à la fois d'assurer une protection optimale de l'utilisateur, la face avant 10 du téléphone portable 2 étant encapsulée par le clapet 5 et les parois latérales 16, tout en autorisant, par la surface de support 6, la communication sans fils avec la borne GSM la plus proche.

Les surfaces textiles, et les matériaux textiles 12 comportant de telles surfaces textiles, peuvent être également utilisés pour d'autres applications que les dispositifs de protection 1 décrits ci-dessus. Elles peuvent être utilisées pour d'autre systèmes de protection contre les ondes électromagnétique, tels que des vêtements à destination des femmes enceintes, d es personne présentant une sensibilité aux ondes électromagnétiques ou encore des personnes possédant un pacemaker.

Les surfaces textiles, et les matériaux textiles comportant de telles surfaces textiles, peuvent également être utilisés pour des applications nécessitant une isolation contre les ondes électromagnétiques, telles que le blindage d'appareils électroniques, qu'ils soient médicaux ou non, ou l'isolation d'un local par rapport aux réseaux de communications sans fil.

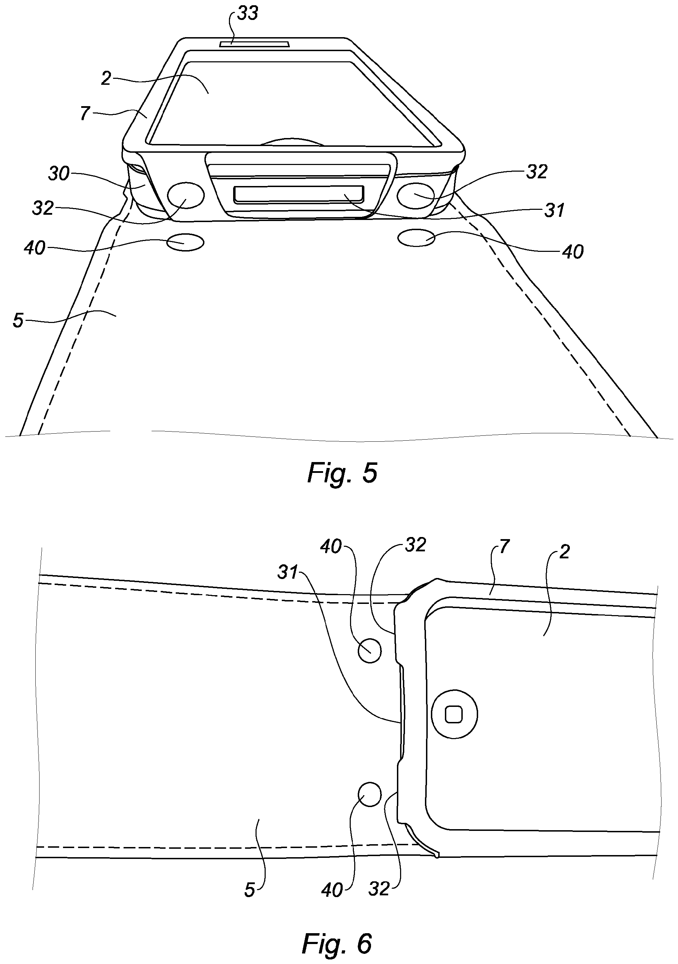

Les figures 5 à 8 illustrent une troisième forme d'exécution du dispositif de protection 1.

Cette troisième forme d'exécution est identique à la première forme d'exécution à l'exception que le berceau 7 s'étend sur tout le pourtour de la surface de support 6.

Le berceau 7 est conformé pour permettre l'accès à une prise 31 (illustrée à la figure 5) de recharge de la batterie du téléphone portable 2.

Le berceau 7 présente des orifices 32 agencés pour être positionnés centrés face à des microphones du téléphone portable 2, lorsque ce dernier est reçu dans le berceau 7.

Le berceau 7 présente un orifice 33 agencé pour être positionné centré face à un haut-parleur du téléphone portable 2, lorsque ce dernier est reçu dans le berceau 7.

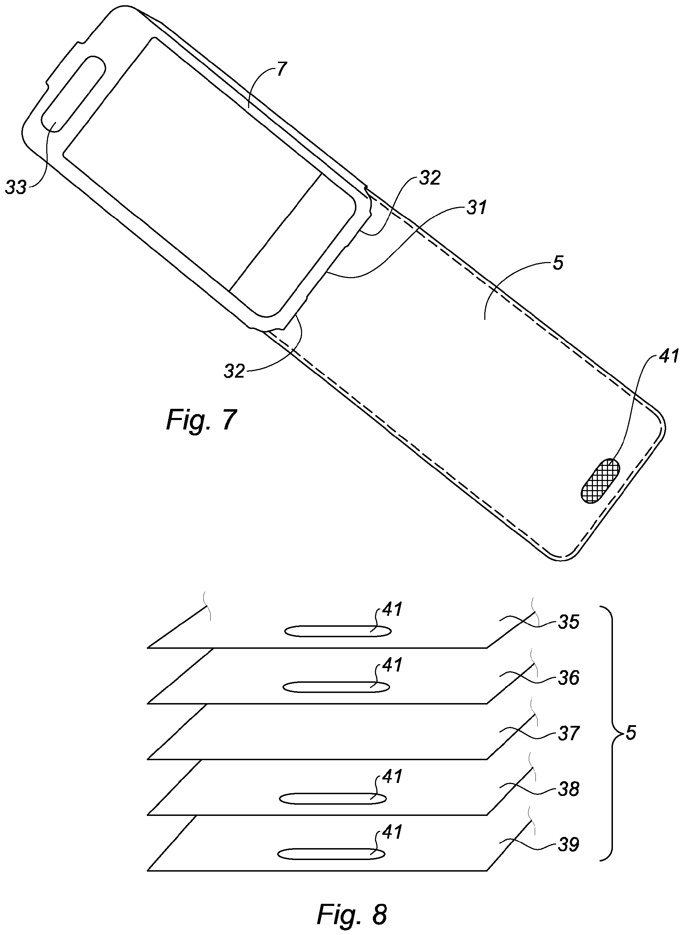

Le clapet 5 est réalisé par empilement (illustré à la figure 8) successif :
- d'une couche 35 formant parement extérieur, par exemple réalisée en cuir ou en matière plastique ;
- d'une couche 36 formant renfort, par exemple réalisée en plexiglas ;
- d'une couche 37 formant zone de protection, réalisée dans une surface textile, ou un matériau textile 12 comportant au moins deux surfaces textiles telles que présentées ci-avant ;
- d'une couche 38, par exemple réalisée en carton ; et
- d'une couche 39 formant parement intérieur, par exemple réalisée en suédine.

Les couches 35, 36, 38 et 39 comprennent chacune deux orifices 40 agencés de telle sorte que lorsque le clapet 5 est positionné en position fermée, les orifices 40 sont positionnés centrés face aux microphones du téléphone portable.

Les orifices 40 permettent de limiter l'atténuation des ondes acoustiques captées par le microphone du téléphone portable, lorsque le clapet 5 est positionné en position fermée.

En outre, les couches 35, 36, 38 et 39 comprennent chacune un orifice 41 agencé de telle sorte que lorsque le clapet 5 est positionné en position fermée, chaque orifice 41 est positionné centré face au haut-parleur du téléphone portable.

Les orifices 41 permettent de limiter l'atténuation des ondes acoustiques générées par le haut-parleur du téléphone portable, lorsque le clapet 5 est positionné en position fermée.

La couche 37 est dépourvue d'orifices 40 et 41, de manière à interdire le passage des ondes électromagnétiques à travers le capot et assurer la protection de l'utilisateur en conditions d'utilisation.

Comme il va de soi, l'invention ne se limite pas aux seules formes d'exécution de ces surfaces textiles et matériaux textiles pour absorber les ondes électromagnétiques et des dispositifs de protection, décrits ci-dessus à titre d'exemples.

Les métaux employés pourraient notamment être d'autres métaux que l'argent et l'acier.

## Revendications

1. Surface textile configurée pour absorber au moins partiellement des ondes électromagnétiques qui comporte des éléments textiles, tels que des fils ou des fibres, d'au moins un premier et un deuxième types, les éléments textiles du premier et du deuxième types présentant des propriétés de conduction électrique, **caractérisée en ce que** chaque élément textile du premier type comporte une âme en matière synthétique recouverte d'un premier métal, les éléments textiles du deuxième type étant réalisés dans un deuxième métal.

2. Surface textile selon la revendication 1, **caractérisée en ce que** le premier métal est de l'argent.

3. Surface textile selon la revendication 1 ou 2, **caractérisée en ce que** l'âme des éléments textiles du premier type est réalisée dans un polymère du type polyamide.

4. Surface textile selon l'une des revendications 1 à 3, **caractérisée en ce que** le deuxième métal est de l'acier ou un alliage d'acier.

5. Surface textile selon l'une des revendications 1 à 4, **caractérisée en ce que** qu'elle comporte en outre des éléments textiles d'un troisième type réalisés en matériau isolant électriquement, tel que du polyester.

6. Surface textile selon la revendication 5, **caractérisée en ce que** la surface textile comporte des torons ou des guipures formés respectivement par le retordage ou le guipage d'au moins un élément du troisième type avec au moins un élément textile du premier type ou du deuxième type.

7. Surface textile selon l'une des revendications 1 à 6, **caractérisée en ce qu'**elle est obtenue par tissage, la surface textile présentant des fils de trame (14) comportant des éléments textiles du premier ou du deuxième type, la surface textile présentant des fils de chaîne (15) comportant des éléments textiles d'un type différent, parmi les éléments textiles du premier et du deuxième types.

8. Surface textile selon la revendication 7, **caractérisée en ce qu'**elle est constituée à partir de fils de polyamide recouverts d'argent pour les fils de trame (14) ou de chaîne (15) et de fils en acier inoxydable/polyester pour les fils respectivement de chaîne (15) ou de trame (14).

9. Matériau textile (12) pour absorber au moins partiellement les ondes électromagnétiques, **caractérisé en ce qu'**il comporte au moins deux couches formées chacune d'une surface textile selon l'une des revendications 1 à 8.

10. Dispositif de protection (1) contre les ondes électromagnétiques destiné à loger un téléphone portable (2), le dispositif comportant :
- un logement (7) destiné à recevoir le téléphone portable (2) et
- au moins une zone de protection (13) destinée à être interposée entre la tête d'un utilisateur et le téléphone portable (2),
le dispositif étant **caractérisé en ce que** ladite zone de protection (13) comporte une surface textile selon l'une des revendications 1 à 8 ou un matériau textile (12) selon la revendication 9.

11. Dispositif de protection (1) selon la revendication 10, **caractérisé en ce que** le dispositif comporte un clapet (5) qui, comportant la zone de protection (13), est mobile entre une position ouverte dans laquelle le clapet (5) est destiné à être positionné en retrait du téléphone portable (2) reçu dans le logement (7), et une position fermée dans laquelle le clapet (5) est destiné à être positionné contre la face avant du téléphone portable.

12. Dispositif de protection (1) selon la revendication 11, **caractérisé en ce que** le clapet (5) est réalisé par empilement d'au moins :
- une première couche (37) formant ladite zone de protection (13), réalisée dans une surface textile selon l'une des revendications 1 à 8 ou un matériau textile (12) selon la revendication 9 ; et
- une deuxième couche (35) formant parement extérieur, cette deuxième couche (35) comprenant au moins un premier orifice (40) agencé de telle sorte que lorsque le clapet (5) est positionné en position fermée, chaque premier orifice (40) est positionné centré face à un microphone du téléphone portable (2).

13. Dispositif de protection (1) selon la revendication 12, **caractérisé en ce que** la deuxième couche (35) formant parement extérieur comprend au moins un second orifice (41) agencé de telle sorte que lorsque le clapet (5) est positionné en position fermée, chaque second orifice (41) est positionné centré face à un haut-parleur du téléphone portable (2).

14. Dispositif de protection (1) selon l'une quelconque des revendications 12 ou 13, **caractérisé en ce que** la deuxième couche (35) est réalisée en cuir ou en matière plastique.

15. Dispositif de protection (1) selon l'une quelconque des revendications 12 à 14, **caractérisé en ce que** l'empilement comprend en outre une troisième couche (39) formant parement intérieur, cette troisième couche (39) comprenant au moins un premier orifice (40), et de préférence au moins un second orifice (41), agencés de telle sorte que lorsque le clapet (5) est positionné en position fermée, chaque premier orifice (40) est positionné centré face à un microphone du téléphone portable (2), et chaque second orifice (41) est positionné centré face à un haut-parleur du téléphone portable (2).

16. Dispositif de protection (1) selon la revendication 15, **caractérisé en ce que** la troisième couche (39) est réalisée en suédine.

17. Dispositif de protection (1) selon l'une quelconque des revendications 12 à 16, **caractérisé en ce que** l'empilement comprend en outre une quatrième couche (36) formant renfort, disposé entre les deuxième et troisième couches (35, 39), cette quatrième couche (36) comprenant au moins un premier orifice (40), et de préférence au moins un second orifice (41), agencés de telle sorte que lorsque le clapet (5) est positionné en position fermée, chaque premier orifice est positionné centré face à un microphone du téléphone portable, et chaque second orifice (41) est positionné centré face à un haut-parleur du téléphone portable (2).

18. Dispositif de protection (1) selon la revendication 17, **caractérisé en ce que** la quatrième couche (36) est réalisée en plexiglas.

19. Dispositif de protection (1) selon la revendication 17, **caractérisé en ce que** l'empilement comprend une cinquième couche (38) réalisée en carton, cette cinquième couche (38) comprenant au moins un premier orifice (40), et de préférence au moins un second orifice (41), agencés de telle sorte que lorsque le clapet (5) est positionné en position fermée, chaque premier orifice (40) est positionné centré face à un microphone du téléphone portable (2), et chaque second orifice (41) est positionné centré face à un haut-parleur du téléphone portable.

20. Dispositif selon l'une quelconque des revendications 12 à 19, **caractérisé en ce que** le logement (7) est pourvu d'au moins un premier orifice (32) agencé pour être positionné centré face à un microphone du téléphone portable, et de préférence d'au moins un second orifice (33) agencé pour être positionné centré face à un haut-parleur du téléphone portable, lorsque ledit téléphone portable (2) est reçu dans le logement (7).

## Patentansprüche

1. Textile Fläche, die konfiguriert ist, um mindestens teilweise elektromagnetische Wellen zu absorbieren, welche textile Elemente, wie Fäden oder Fasern mindestens eines ersten und eines zweiten Typs beinhaltet, wobei die textilen Elemente des ersten und zweiten Typs Eigenschaften elektrischer Leitfähigkeit aufweisen, **dadurch gekennzeichnet, dass** jedes textile Element des ersten Typs einen Kern aus synthetischem Material beinhaltet, der mit einem ersten Metall bedeckt ist, wobei die textilen Elemente des zweiten Typs aus einem zweiten Metall realisiert sind.

2. Textile Fläche nach Anspruch 1, **dadurch gekennzeichnet, dass** das erste Metall Silber ist.

3. Textile Fläche nach Anspruch 1 oder 2, **dadurch gekennzeichnet, dass** der Kern der textilen Elemente des ersten Typs aus einem Polymer des Typs Polyamid realisiert ist.

4. Textile Fläche nach einem der Ansprüche 1 bis 3, **dadurch gekennzeichnet, dass** das zweite Metall Stahl oder eine Stahllegierung ist.

5. Textile Fläche nach einem der Ansprüche 1 bis 4, **dadurch gekennzeichnet, dass** sie weiter textile Elemente eines dritten Typs beinhaltet, die aus einem elektrisch isolierenden Material, wie Polyester, realisiert sind.

6. Textile Fläche nach Anspruch 5, **dadurch gekennzeichnet, dass** die textile Fläche Bänder oder Gipüren beinhaltet, die jeweils durch die Verdrillung oder die Umspannung mindestens eines Elements des dritten Typs mit mindestens einem textilen Element des ersten Typs oder des zweiten Typs gebildet werden.

7. Textile Fläche nach einem der Ansprüche 1 bis 6, **dadurch gekennzeichnet, dass** sie durch Weben erhalten wird, wobei die textile Fläche Schussfäden (14) aufweist, die textile Elemente des ersten oder des zweiten Typs beinhalten, wobei die textile Fläche Kettfäden (15) aufweist, die textile Elemente eines unterschiedlichen Typs aus den textilen Elementen des ersten und des zweiten Typs beinhalten.

8. Textile Fläche nach Anspruch 7, **dadurch gekennzeichnet, dass** sie aus mit Silber überzogenen Polyamidfäden für die Schuss- (14) oder Kettfäden (15) gebildet wird, und aus Fäden aus nichtrostendem Stahl/ Polyester für jeweils die Kett- (15) oder Schussfäden (14).

9. Textilmaterial (12) zum mindestens teilweisen Absorbieren der elektromagnetischen Wellen, **dadurch gekennzeichnet, dass** es mindestens zwei Lagen beinhaltet, die jeweils aus einer textilen Fläche nach einem der Ansprüche 1 bis 8 gebildet sind.

10. Schutzvorrichtung (1) gegen die elektromagnetischen Wellen, die dazu bestimmt ist, ein Mobiltelefon (2) aufzunehmen, wobei die Vorrichtung Folgendes beinhaltet:
- eine Aufnahme (7), die dazu bestimmt ist, das Mobiltelefon (2) zu empfangen, und
- mindestens eine Schutzzone (13), die dazu bestimmt ist, zwischen dem Kopf eines Nutzers und das Mobiltelefon (2) eingesetzt zu werden,
wobei die Vorrichtung **dadurch gekennzeichnet ist, dass** die Schutzzone (13) eine textile Fläche nach einem der Ansprüche 1 bis 8 oder ein Textilmaterial (12) nach Anspruch 9 beinhaltet.

11. Schutzvorrichtung (1) nach Anspruch 10, **dadurch gekennzeichnet, dass** die Vorrichtung eine Klappe (5) beinhaltet, welche, die Schutzzone (13) beinhaltend, zwischen einer offenen Position, in der die Klappe (5) dazu bestimmt ist, vom in der Aufnahme (7) empfangenen Mobiltelefon (2) zurückgezogen positioniert zu sein, und einer geschlossenen Position beweglich zu sein, in der die Klappe (5) dazu bestimmt ist, an der Vorderseite des Mobiltelefons positioniert zu sein.

12. Schutzvorrichtung (1) nach Anspruch 11, **dadurch gekennzeichnet, dass** die Klappe (5) durch Stapeln von mindestens Folgendem realisiert ist:
- einer ersten Lage (37), welche die Schutzzone (13) bildet, die auf einer textilen Fläche nach einem der Ansprüche 1 bis 8 oder einem Textilmaterial (12) nach Anspruch 9 realisiert ist; und
- einer zweiten Lage (35), die eine Außenverkleidung bildet, wobei diese zweite Lage (35) mindestens eine erste Öffnung (40) umfasst, die derart angeordnet ist, dass, wenn die Klappe (5) in geschlossener Position positioniert ist, jede erste Öffnung zentriert gegenüber einem Mikrofon des Mobiltelefons (2) positioniert ist.

13. Schutzvorrichtung (1) nach Anspruch 12, **dadurch gekennzeichnet, dass** die zweite Lage (35), die eine Außenverkleidung bildet, mindestens eine zweite Öffnung (41) umfasst, die derart angeordnet ist, dass, wenn die Klappe (5) in geschlossener Position positioniert ist, jede zweite Öffnung (41) zentriert gegenüber einem Lautsprecher des Mobiltelefons (2) positioniert ist.

14. Schutzvorrichtung (1) nach einem der Ansprüche 12 oder 13, **dadurch gekennzeichnet, dass** die zweite Lage (35) aus Leder oder aus Kunststoffmaterial realisiert ist.

15. Schutzvorrichtung (1) nach einem der Ansprüche 12 bis 14, **dadurch gekennzeichnet, dass** die Stapelung weiter eine dritte Lage (39) umfasst, welche eine Innenverkleidung bildet, wobei diese dritte Lage (39) mindestens eine erste Öffnung (40), und vorzugsweise mindestens eine zweite Öffnung (41) umfasst, die derart angeordnet sind, dass, wenn die Klappe (5) in geschlossener Position positioniert ist, jede erste Öffnung (40) zentriert gegenüber einem Mikrofon des Mobiltelefons (2) positioniert ist, und jede zweite Öffnung (41) zentriert gegenüber einem Lautsprecher des Mobiltelefons (2) positioniert ist.

16. Schutzvorrichtung (1) nach Anspruch 15, **dadurch gekennzeichnet, dass** die dritte Lage (39) aus Kunstleder realisiert ist.

17. Schutzvorrichtung (1) nach einem der Ansprüche 12 bis 16, **dadurch gekennzeichnet, dass** die Stapelung weiter eine vierte Lage (36) umfasst, die eine Verstärkung bildet, die zwischen der zweiten und dritten Lage (35, 39) angeordnet ist, wobei diese vierte Lage (36) mindestens eine erste Öffnung (40), und vorzugsweise mindestens eine zweite Öffnung (41) umfasst, die derart angeordnet sind, dass, wenn die Klappe (5) in geschlossener Position positioniert ist, jede erste Öffnung zentriert gegenüber einem Mikrofon des Mobiltelefons positioniert ist, und jede zweite Öffnung (41) zentriert gegenüber einem Lautsprecher des Mobiltelefons (2) positioniert ist.

18. Schutzvorrichtung (1) nach Anspruch 17, **dadurch gekennzeichnet, dass** die vierte Lage (36) aus Plexiglas realisiert ist.

19. Schutzvorrichtung (1) nach Anspruch 17, **dadurch gekennzeichnet, dass** die Stapelung eine fünfte, aus Karton realisierte Lage (38) umfasst, wobei diese fünfte Lage (38) mindestens eine erste Öffnung (40), und vorzugsweise mindestens eine zweite Öffnung (41) umfasst, die derart angeordnet sind, dass, wenn die Klappe (5) in geschlossener Position positioniert ist, jede erste Öffnung (40) zentriert gegenüber einem Mikrofon des Mobiltelefons (2) positioniert ist, und jede zweite Öffnung (41) zentriert gegenüber einem Lautsprecher des Mobiltelefons positioniert ist.

20. Vorrichtung nach einem der Ansprüche 12 bis 19, **dadurch gekennzeichnet, dass** die Aufnahme (7) mit mindestens einer ersten Öffnung (32) versehen ist, die angeordnet ist, um zentriert gegenüber einem Mikrofon des Mobiltelefons positioniert zu sein, und vorzugsweise mindestens eine zweite Öffnung (33), die angeordnet ist, um zentriert gegenüber einem Lautsprecher des Mobiltelefons positioniert zu sein, wenn das Mobiltelefon (2) in der Aufnahme (7) empfangen ist.

## Claims

1. A textile surface configured to at least partially absorb electromagnetic waves which include textile elements, such as threads or fibers, of at least first and second types, the textile elements of the first and second types having electrical conduction properties, **characterized in that** each textile element of the first type includes a synthetic-material core covered with a first metal, the textile elements of the second type being made from a second metal.

2. The textile surface according to claim 1, **characterized in that** the first metal is silver.

3. The textile surface according to claim 1 or 2, **characterized in that** the core of the textile elements of the first type is made from a polymer of the polyamide type.

4. The textile surface according to any of claims 1 to 3, **characterized in that** the second metal is steel or a steel alloy.

5. The textile surface according to any of claims 1 to 4, **characterized in that** it further includes textile elements of a third type which are made of electrically insulating material, such as polyester.

6. The textile surface according to claim 5, **characterized in that** the textile surface includes strands or guipures formed respectively by the twisting or the covering of at least one element of the third type with at least one textile element of the first type or the second type.

7. The textile surface according to any of claims 1 to 6, **characterized in that** it is obtained by weaving, the textile surface having weft threads (14) including textile elements of the first or second type, the textile surface having warp threads (15) including textile elements of a different type, among the textile elements of the first and second types.

8. The textile surface according to claim 7, **characterized in that** it is constituted from polyamide threads covered with silver for the weft (14) or warp (15) threads and stainless steel/polyester threads for the warp (15) or weft (14) threads, respectively.

9. A textile material (12) for at least partially absorbing the electromagnetic waves, **characterized in that** it includes at least two layers each formed of a textile surface according to any of claims 1 to 8.

10. A protective device (1) against electromagnetic waves intended to house a mobile telephone (2), the device including:
- a housing (7) intended to receive the mobile telephone (2), and
- at least one protective area (13) intended to be inserted between the head of a user and the mobile telephone (2),
the device being **characterized in that** the protective area (13) includes a textile surface according to any of claims 1 to 8 or a textile material (12) according to claim 9.

11. The protective device (1) according to claim 10, **characterized in that** the device includes a flap (5) which, including the protective area (13), is movable between an open position, in which the flap (5) is intended to be positioned retracted from the mobile telephone (2) received in the housing (7), and a closed position, in which the flap (5) is intended to be positioned against the front face of the mobile telephone.

12. The protective device (1) according to claim 11, **characterized in that** the flap (5) is made by stacking at least:
- one first layer (37) forming said protective area (13), made in a textile surface according to any of claims 1 to 8 or a textile material (12) according to claim 9; and
- a second layer (35) forming an outer facing, this second layer (35) comprising at least one first orifice (40) arranged such that when the flap (5) is positioned in the closed position, each first orifice (40) is positioned centered facing a microphone of the mobile telephone (2).

13. The protective device (1) according to claim 12, **characterized in that** the second layer (35) forming the outer facing comprises at least one second orifice (41) arranged such that when the flap (5) is positioned in the closed position, each second orifice (41) is positioned centered facing a speaker of the mobile telephone (2).

14. The protective device (1) according to any one of claims 12 or 13, **characterized in that** the second layer (35) is made of leather or plastic material.

15. The protective device (1) according to any one of claims 12 to 14, **characterized in that** the stack further comprises a third layer (39) forming an inner facing, this third layer (39) comprising at least one first orifice (40), and preferably at least one second orifice (41), arranged such that when the flap (5) is positioned in the closed position, each first orifice (40) is positioned centered facing a microphone of the mobile telephone (2), and each second orifice (41) is positioned centered facing a speaker of the mobile telephone (2).

16. The protective device (1) according to claim 15, **characterized in that** the third layer (39) is made of suede cloth.

17. The protective device (1) according to any one of claims 12 to 16, **characterized in that** the stack further comprises a fourth layer (36) forming a reinforcement, disposed between the second and third layers (35, 39), this fourth layer (36) comprising at least one first orifice (40), and preferably at least one second orifice (41), arranged such that when the flap (5) is positioned in the closed position, each first orifice is positioned centered facing a microphone of the mobile telephone, and each second orifice (41) is positioned centered facing a speaker of the mobile telephone (2).

18. The protective device (1) according to claim 17, **characterized in that** the fourth layer (36) is made of Plexiglas.

19. The protective device (1) according to claim 17, **characterized in that** the stack comprises a fifth layer (38) made of cardboard, this fifth layer (38) comprising at least one first orifice (40), and preferably at least one second orifice (41), arranged such that when the flap (5) is positioned in the closed position, each first orifice (40) is positioned centered facing a microphone of the mobile telephone (2), and each second orifice (41) is positioned centered facing a speaker of the mobile telephone.

20. The device according to any one of claims 12 to 19, **characterized in that** the housing (7) is provided with at least one first orifice (32) arranged to be positioned centered facing a microphone of the mobile telephone, and preferably at least one second orifice (33) arranged to be positioned centered facing a speaker of the mobile telephone, when said mobile telephone (2) is received in the housing (7).
